# DEMANDE DE BREVET EUROPEEN

(11) **EP 4 572 112 A1**
(43) Date de publication de la demande: **18.06.2025**
(21) Numéro de dépôt: 24217809.3
(22) Date de dépôt: 05.12.2024
(51) Int. Cl.: H02M 1/088, H02M 7/00, H02M 7/5387, H05K 7/14, H01L 25/07, H02M 1/38

(54) **MODULE DE PUISSANCE ET CONVERTISSEUR STATIQUE DE PUISSANCE**

(30) Priorité: 14.12.2023 FR 2314133
(71) Demandeur: Commissariat à l'Energie Atomique et aux Energies Alternatives, 75015 Paris (FR)
(72) Inventeur: ALVES RODRIGUES, Luis-Gabriel, 38054 GRENOBLE CEDEX 09 (FR)
(74) Mandataire: Cabinet Beaumont

(57) **Abrégé**

Module de puissance (1000.1, 1000.2), comprenant *2n* interrupteurs (102) destinés à former n cellules de commutation entre un premier contact électrique (104.1, 104.2) et *n* deuxièmes contacts électriques (106.1 - 106.3), n étant supérieur ou égal à 2, chacun des deuxièmes contacts étant couplé à deux des interrupteurs, comprenant un circuit de pilotage des interrupteurs, et dans lequel :
- les interrupteurs sont juxtaposés deux à deux ;
- chacune des cellules est formée par deux premiers interrupteurs couplés à des deuxièmes contacts différents et juxtaposés, et par deux deuxièmes interrupteurs chacun couplé à l'un des deuxièmes contacts différents ;
- le circuit de pilotage est configuré pour commander les interrupteurs tel que, lors d'une commutation de chacune des cellules de commutation, l'un des deuxièmes interrupteurs est ouvert, puis l'un des premiers interrupteurs est fermé, puis l'autre premier interrupteur est ouvert, puis l'autre deuxième interrupteur est fermé.

## Description

### Domaine technique

La présente description concerne de façon générale le domaine de la conversion électrique de puissance, et notamment celui des convertisseurs statiques de puissance et des modules de puissance (« Power Modules » en anglais) de tels convertisseurs.

### Technique antérieure

Un convertisseur statique de puissance DC/AC (conversion d'une énergie électrique continue en une énergie électrique alternative) ou AC/DC (conversion d'une énergie électrique alternative en une énergie électrique continue) comporte des interrupteurs et des éléments passifs (condensateurs, inductances, résistances). Selon la nature des sources (capacitive ou inductive) DC et AC, des interrupteurs bidirectionnels en tension, ou bidirectionnels en courant et en tension, sont utilisés dans le convertisseur.

Des composants semi-conducteurs verticaux ou horizontaux, par exemple des transistors de type MOSFET, IGBT et HEMT, ou des diodes, sont généralement utilisés pour réaliser les interrupteurs des convertisseurs statiques de puissance. Chaque interrupteur bidirectionnel en tension est par exemple formé par un transistor MOSFET, HEMT ou IGBT couplé en série à une diode, ou deux transistors MOSFET, HEMT ou IGBT couplés en anti-série l'un à l'autre. Les métallisations, ou connectiques électriques, pour les composants verticaux sont présentes sur des faces avant et arrière de l'empilement de matériaux formant ces composants.

Dans un convertisseur DC/AC de type onduleur de courant et AC/DC de type redresseur de tension, les interrupteurs peuvent être répartis en deux groupes appelés « low-side », ou côté bas, et « high-side », ou côté haut, selon leurs points de connexion communs (appelé côté « N » ou négatif lorsque ce point de connexion commun est couplé à une borne négative de la source d'énergie électrique dans le cas des interrupteurs « low-side », ou côté « P » ou positif lorsque ce point de connexion commun est couplé à une borne positive de la source d'énergie électrique dans le cas des interrupteurs « high-side »). Par exemple, les cellules de commutations formées par les interrupteurs d'un tel convertisseur sont au nombre de trois par groupe pour un convertisseur statique de puissance triphasé.

Afin d'imposer les mêmes contraintes de fonctionnement à tous les interrupteurs du convertisseur, toutes les cellules de commutation du convertisseur présentent les mêmes éléments parasites (par exemple des inductances parasites). De plus, pour réduire ces éléments parasites, tous les interrupteurs d'un même groupe peuvent être intégrés dans un même module de puissance. Les deux modules de puissance intégrés dans le convertisseur, l'un comprenant les interrupteurs « low-side » (côté bas) et l'autre comprenant les interrupteurs « high-side » (côté haut), sont réalisés de manière identique afin que toutes les cellules de commutation du convertisseur présentent les mêmes éléments parasites. Dans une autre configuration, il est possible que les interrupteurs des deux groupes « high-side » et « low-side » soient intégrés dans un même module de puissance.

Une première configuration d'un module de puissance consiste à disposer chaque groupe de puces formant les composants de chaque interrupteur parallèlement les uns aux autres, et juxtaposés les uns à côté des autres. Par exemple, en considérant trois cellules de commutation formées selon cette première configuration, avec un interrupteur central juxtaposé à deux interrupteurs latéraux, deux d'entre elles sont dites « courte » car elles sont formées par deux interrupteurs juxtaposés l'un à l'autre (un des interrupteurs latéraux et l'interrupteur central), et la troisième cellule est dite « longue » car elle est formée par deux interrupteurs non juxtaposés l'un à l'autre (les deux interrupteurs latéraux). Un problème lié à cette première configuration est que les propriétés des cellules de commutation obtenues ne sont pas identiques les unes par rapport aux autres car tous les composants des interrupteurs ne sont pas soumis aux mêmes contraintes de fonctionnement (électriques et/ou thermiques). Par exemple, compte tenu de la vitesse de commutation élevée des cellules, les inductances parasites génèrent des surtensions différentes entre les puces, pouvant engendrer des différences de vieillissement entre les puces. Cela peut compromettre la fiabilité du module. Ce problème est accentué lorsque des composants semi-conducteurs de puissance dits à grand gap, comprenant par exemple du SiC ou du GaN, sont utilisés.

Une deuxième configuration d'un module de puissance consiste à disposer les puces formant les composants de chaque interrupteur en étoile autour d'un point central du module, chaque branche de cette étoile étant formée par un des interrupteurs. En disposant les interrupteurs tels que les angles formés entre deux branches voisines de l'étoile soient tous égaux, les propriétés des cellules de commutation obtenues sont bien identiques. L'équilibrage des contraintes sur les puces est assuré pour toutes les cellules de commutation. Par contre, cette deuxième configuration est plus encombrante que la première, le substrat étant dans ce cas mal utilisé (notamment lorsque celui-ci présente une forme carrée ou rectangulaire car beaucoup de surface du substrat est inutilisée) ou ayant un facteur de forme peu arrangeant.

### Résumé de l'invention

Il existe donc un besoin de proposer un module de puissance et un convertisseur statique de puissance ne présentant pas un ou plusieurs des inconvénients précédemment décrits.

Un mode de réalisation pallie tout ou partie de ces inconvénients et propose un module de puissance, comprenant au moins 2n interrupteurs destinés à former n cellules de commutation entre un premier contact électrique et n deuxièmes contacts électriques, n étant un nombre entier supérieur ou égal à 2, chacun des deuxièmes contacts électriques étant couplé à au moins deux des interrupteurs, comprenant en outre un circuit de pilotage des interrupteurs, et dans lequel :
- les interrupteurs sont juxtaposés deux à deux les uns à côté des autres ;
- chacune des cellules de commutation est destinée à être formée par deux premiers des interrupteurs couplés à des deuxièmes contacts électriques différents et juxtaposés l'un à côté de l'autre, et par deux deuxièmes des interrupteurs chacun couplé à l'un desdits deuxièmes contacts électriques différents ;
- le circuit de pilotage est configuré pour commander les interrupteurs tel que, lors d'une commutation de chacune des cellules de commutation, l'un des deuxièmes interrupteurs passe de l'état fermé à l'état ouvert, puis l'un des premiers interrupteurs passe de l'état ouvert à l'état fermé, puis l'autre des premiers interrupteurs passe de l'état fermé à l'état ouvert, puis l'autre des deuxièmes interrupteurs passe de l'état ouvert à l'état fermé.

Selon un mode de réalisation particulier, n est un nombre entier supérieur ou égal à 3.

Selon un mode de réalisation particulier, deux des interrupteurs sont couplés à l'un des deuxièmes contacts électriques, les autres interrupteurs étant disposés entre lesdits deux des interrupteurs.

Selon un mode de réalisation particulier, pour chacune des cellules de commutation, les deuxièmes contacts électriques différents auxquels sont couplés les deux deuxièmes interrupteurs sont juxtaposés l'un à côté de l'autre.

Selon un mode de réalisation particulier, le circuit de pilotage est configuré tel que, lors de la commutation de chacune des cellules de commutation :
- après le passage de l'état fermé à l'état ouvert dudit un des deuxièmes interrupteurs, ledit un des premiers interrupteurs passe de l'état ouvert à l'état fermé après une première période d'attente dont la durée est inférieure à 1 µs, et/ou
- après le passage de l'état ouvert à l'état fermé dudit un des premiers interrupteurs, ledit autre des premiers interrupteurs passe de l'état fermé à l'état ouvert après une période de chevauchement dont la durée est inférieure à 1 µs, et/ou
- après le passage de l'état fermé à l'état ouvert dudit autre des premiers interrupteurs, ledit autre des deuxièmes interrupteurs passe de l'état ouvert à l'état fermé après une deuxième période d'attente dont la durée est inférieure à 1 µs.

Selon un mode de réalisation particulier, le module de puissance comporte un empilement de couches électriquement conductrices isolées électriquement entre elles et formant les deuxièmes contacts électriques.

Selon un mode de réalisation particulier, les interrupteurs sont bidirectionnels en tension, ou bidirectionnels en tension et en courant.

Selon un mode de réalisation particulier, chaque interrupteur comporte un transistor et une diode couplés en anti-série, ou deux transistors couplés en anti-série l'un à l'autre.

Selon un mode de réalisation particulier, les interrupteurs comportent des composants de puissance à base de semi-conducteur à grand gap tel que du SiC et/ou du GaN.

Il est également proposé un convertisseur statique de puissance, comprenant au moins un module de puissance selon un mode de réalisation particulier.

Selon un mode de réalisation particulier, le module de puissance est agencé dans un boîtier comprenant, sur une face, des plots de connexions couplés électriquement aux premiers et deuxièmes contacts électriques et à des électrodes de commande des interrupteurs.

Selon un mode de réalisation particulier, le convertisseur statique de puissance est configuré pour être couplé à au moins une source d'énergie électrique, et chacun des interrupteurs du module de puissance est dimensionné pour faire passer une valeur de courant proportionnelle à celle du courant destiné à être délivré par la source d'énergie électrique.

Selon un mode de réalisation particulier, chacun des interrupteurs du module de puissance est dimensionné pour faire passer une valeur de courant égale à la moitié de celle du courant destiné à être délivré par la source d'énergie électrique.

Selon un mode de réalisation particulier, les n deuxièmes contacts électriques sont communs aux interrupteurs du côté haut et aux interrupteurs du côté bas du convertisseur statique de puissance.

Selon un mode de réalisation particulier, les n deuxièmes contacts électriques sont agencés entre les interrupteurs du côté haut et les interrupteurs du côté bas.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 représente schématiquement deux modules de puissance d'un exemple de convertisseur statique de puissance selon un mode de réalisation particulier ;
- la figure 2 représente schématiquement un exemple d'un convertisseur statique de puissance selon un mode de réalisation particulier ;
- la figure 3 représente schématiquement des exemples de réalisation d'interrupteurs bidirectionnels en tension utilisés dans un module de puissance selon un mode de réalisation particulier ;
- la figure 4 représente schématiquement des exemples de réalisation de composants semi-conducteurs de puissance utilisés pour la réalisation d'interrupteurs d'un module de puissance selon un mode de réalisation particulier ;
- la figure 5 représente schématiquement un exemple de configuration et d'agencement des composants au sein d'un module de puissance selon un mode de réalisation particulier ;
- la figure 6 représente schématiquement un exemple de couches électriquement conductrices et isolées entre elles, utilisées pour former les deuxièmes contacts électriques d'un module de puissance selon un mode de réalisation particulier ;
- la figure 7 représente schématiquement un exemple de réalisation d'un module de puissance intégré selon un mode de réalisation particulier ;
- la figure 8 représente schématiquement une vue en coupe d'un module de puissance intégré selon un mode de réalisation particulier ;
- la figure 9 représente schématiquement un chronogramme d'exemples de signaux de commande d'interrupteurs d'une des cellules de commutation d'un module de puissance selon un mode de réalisation particulier.

### Description des modes de réalisation

Des mêmes éléments ont été désignés par des mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments et circuits (composants des interrupteurs, circuit de pilotage, etc.) n'est pas détaillée. L'homme du métier sera à même de réaliser de manière détaillée les différentes fonctions décrites à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "latéral", etc., ou à des qualificatifs d'orientation, tels que les termes "horizontal", "vertical", etc., il est fait référence sauf précision contraire à l'orientation des figures. Toutefois, ces termes ne présument pas de la position et de l'orientation réelles du dispositif lors de son utilisation.

Sauf précision contraire, les expressions "environ", "approximativement", "sensiblement", et "de l'ordre de" signifient à 10 % près, de préférence à 5 % près.

Dans les exemples de réalisation décrits ci-dessous, un convertisseur statique de puissance comporte un ou plusieurs modules de puissance formés de composants actifs, ainsi que des composants passifs tels que des inductances, des capacités, etc. Les composants actifs d'un module de puissance correspondent à des interrupteurs.

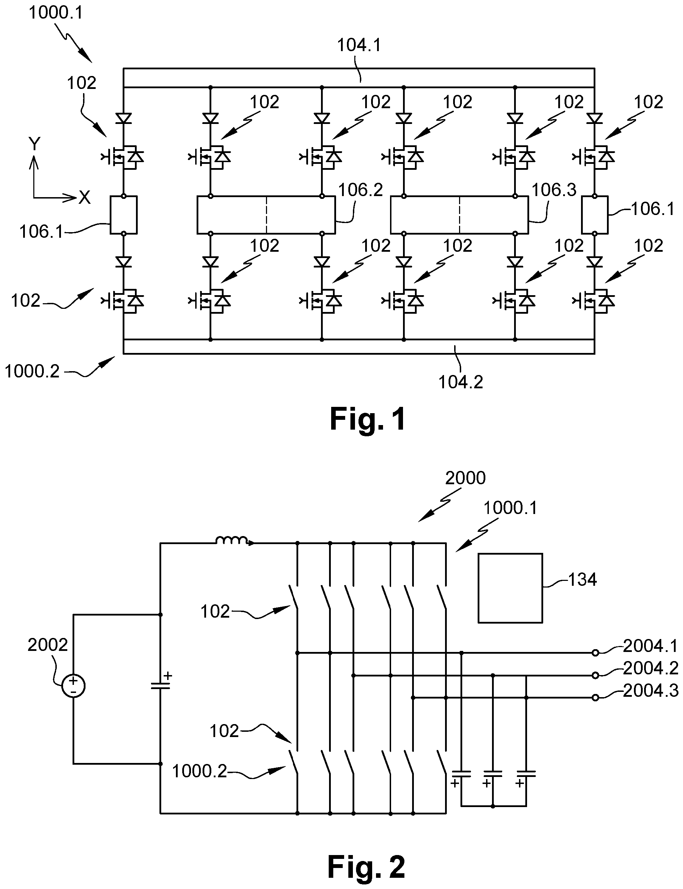

Un exemple de modules de puissance 1000.1, 1000.2 pouvant faire partie d'un convertisseur statique de puissance, selon un mode de réalisation particulier, est décrit ci-dessous en lien avec la figure 1. Ces modules de puissance 1000.1 et 1000.2 correspondent par exemple à ceux du convertisseur statique de puissance 2000 représenté sur la figure 2.

Sur l'exemple de la figure 1, le module 1000.1 correspond au module dit « high-side » et le module 1000.2 correspond au module dit « low-side » du convertisseur statique de puissance 2000.

Chaque module 1000.1, 1000.2 comporte au moins 2n interrupteurs 102 destinés à former n cellules de commutation entre un premier contact électrique et n deuxièmes contacts électriques, n étant un nombre entier supérieur ou égal à 2. Sur l'exemple de la figure 1, n = 3. Une telle configuration est par exemple adaptée lorsque le convertisseur 2000, incluant ces modules 1000.1 et 1000.2, est configuré pour réaliser une conversion de courant ou de tension avec d'un côté une tension, ou un courant, continue destinée à être obtenue entre les premiers contacts électriques des modules 1000.1, 1000.2, et de l'autre des tensions, ou courants, triphasées destinées à être obtenues sur chacun des deuxièmes contacts électriques.

A titre d'exemple, lorsque n = 3, le convertisseur 2000 peut correspondre à un onduleur de courant et/ou un redresseur de tension triphasé assurant la conversion entre une source de tension, ou de courant, continue, par exemple un panneau photovoltaïque, couplée aux premiers contacts électriques des modules 1000.1, 1000.2, et des tensions triphasées par exemple destinées à être injectées et/ou reçues sur un réseau ou une machine tournante telle qu'un moteur et obtenues sur les deuxièmes contacts électriques des modules 1000.1, 1000.2. La figure 2 représente une telle configuration du convertisseur 2000 qui forme un onduleur de courant couplé électriquement à un panneau photovoltaïque 2002 (symbolisé sous la forme d'une source de tension continue) et à des connexions 2004.1 - 2004.3 de tensions triphasées. Sur la figure 2, le convertisseur 2000 comporte également des composants passifs tels que des capacités et inductances qui ne sont pas décrites en détail ici.

En variante, il est possible que n soit supérieur à 3.

Les interrupteurs 102 de chacun des modules 1000.1, 1000.2 sont juxtaposés deux à deux les uns à côté des autres. Sur l'exemple de la figure 1, les interrupteurs 102 de chaque module 1000.1, 1000.2 sont disposés les uns à côté des autres le long d'une direction parallèle à l'axe X. Dans chaque module 1000.1, 1000.2, les interrupteurs 102 sont donc agencés parallèlement les uns à côté des autres en occupant ensemble une surface rectangulaire ou carrée.

Sur l'exemple de la figure 1, chacun des interrupteurs 102 du premier module 1000.1 comporte une première borne de connexion couplée électriquement à un premier contact électrique 104.1. Dans cet exemple, une borne positive d'une source d'énergie électrique, non visible sur la figure 1, est destinée à être couplée électriquement à ce premier contact électrique 104.1. En outre, dans cet exemple, chacun des interrupteurs 102 du deuxième module 1000.2 comporte une première borne de connexion couplée électriquement à un autre premier contact électrique 104.2 auquel une borne négative de la source d'énergie électrique est destinée à être couplée électriquement.

En outre, sur l'exemple de la figure 1, chacun des interrupteurs 102 du premier module 1000.1 et du deuxième module 1000.2 comporte une deuxième borne de connexion couplée électriquement à l'un des n deuxièmes contacts électriques, référencés 106.1 - 106.3 sur la figure 1. Chacun des deuxièmes contacts électriques 106.1 - 106.3 est couplé électriquement à au moins deux des interrupteurs 102 de chacun des modules 1000.1, 1000.2. Sur l'exemple de la figure 1, chacun des deuxièmes contacts électriques 106.1 - 106.3 est couplé électriquement à deux des interrupteurs 102 de chacun des modules 1000.1, 1000.2. Dans cet exemple, les deuxièmes contacts électriques 106.1 - 106.3 sont communs aux modules 1000.1, 1000.2.

Sur l'exemple de la figure 1, le deuxième contact électrique 106.1 comporte deux parties distinctes et distantes l'une de l'autre mais qui sont reliées électriquement l'une à l'autre pour ne former qu'un seul deuxième contact électrique (la liaison électrique entre ces deux parties n'est pas visible sur la figure 1). De plus, chacun des deuxièmes contacts électriques 106.2, 106.3 comporte deux parties juxtaposées, reliées électriquement entre elles et auxquelles deux interrupteurs 102 de chacun des modules 1000.1, 1000.2 sont couplés électriquement. Sur la figure 1, les deux parties de chacun des deuxièmes contacts électriques 106.2, 106.3 sont symboliquement délimitées par un trait pointillé.

Dans la configuration visible sur la figure 1, pour chacun des modules 1000.1, 1000.2, les interrupteurs 102 couplés aux deuxièmes contacts électriques 106.2, 106.3 sont disposés entre les deux interrupteurs 102 couplés au deuxième contact électrique 106.1. Une configuration possible des parties de ces deuxièmes contacts électriques 106.1 - 106.3 est une disposition côte à côte de ces différentes parties, par exemple parallèlement à l'axe X, dans l'ordre suivant : première partie du contact 106.1 ; première partie du contact 106.2 ; deuxième partie du contact 106.2 ; première partie du contact 106.3 ; deuxième partie du contact 106.3 ; deuxième partie du contact 106.1.

D'autres configurations des interrupteurs 102 et des deuxièmes contacts électriques 106.1 - 106.3 que celle visible sur la figure 1 sont possibles. Par exemple, il est possible que chacun des deuxièmes contacts électriques 106.1 - 106.3 comporte deux parties distinctes et distantes l'une de l'autre et qui sont reliées électriquement l'une à l'autre. Une configuration possible des parties de ces deuxièmes contacts électriques 106.1 - 106.3 est une disposition côte à côte de ces différentes parties, par exemple parallèlement à l'axe X, dans l'ordre suivant : première partie du contact 106.1 ; première partie du contact 106.2 ; première partie du contact 106.3 ; deuxième partie du contact 106.1 ; deuxième partie du contact 106.2 ; deuxième partie du contact 106.3.

Dans chaque module 1000.1, 1000.2, chacune des cellules de commutation est destinée à être formée par deux premiers des interrupteurs 102 couplés à des deuxièmes contacts électriques 106.1 - 106.3 différents et juxtaposés l'un à côté de l'autre, et par deux deuxièmes des interrupteurs 102 chacun couplé à l'un desdits deuxièmes contacts électriques différents 106.1 - 106.3. Sur l'exemple de la figure 1, pour le module 1000.1 :
- une première cellule de commutation est destinée à assurer la commutation entre un premier chemin de conduction s'étendant entre le premier contact électrique 104.1 et le deuxième contact électrique 106.1, et un deuxième chemin de conduction s'étendant entre le premier contact électrique 104.1 et le deuxième contact électrique 106.2 ;
- une deuxième cellule de commutation est destinée à assurer la commutation entre un premier chemin de conduction s'étendant entre le premier contact électrique 104.1 et le deuxième contact électrique 106.2, et un deuxième chemin de conduction s'étend entre le premier contact électrique 104.1 et le deuxième contact électrique 106.3 ;
- une troisième cellule de commutation est destinée à assurer la commutation entre un premier chemin de conduction s'étendant entre le premier contact électrique 104.1 et le deuxième contact électrique 106.3, et un deuxième chemin de conduction s'étendant entre le premier contact électrique 104.1 et le deuxième contact électrique 106.1.

De même, pour le module 1000.2 visible sur la figure 1 :
- une première cellule de commutation est destinée à assurer la commutation entre un premier chemin de conduction s'étendant entre le premier contact électrique 104.2 et le deuxième contact électrique 106.1, et un deuxième chemin de conduction s'étendant entre le premier contact électrique 104.2 et le deuxième contact électrique 106.2 ;
- une deuxième cellule de commutation est destinée à assurer la commutation entre un premier chemin de conduction s'étendant entre le premier contact électrique 104.2 et le deuxième contact électrique 106.2, et un deuxième chemin de conduction s'étendant entre le premier contact électrique 104.2 et le deuxième contact électrique 106.3 ;
- une troisième cellule de commutation est destinée à assurer la commutation entre un premier chemin de conduction s'étendant entre le premier contact électrique 104.2 et le deuxième contact électrique 106.3, et un deuxième chemin de conduction s'étendant entre le premier contact électrique 104.2 et le deuxième contact électrique 106.1.

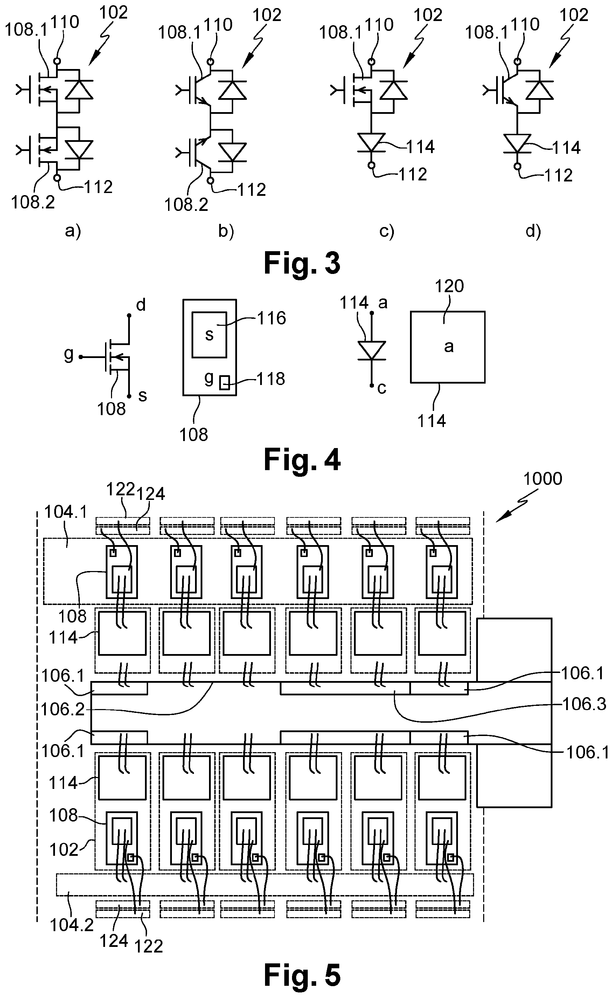

Dans une configuration particulière, les interrupteurs 102 des modules 1000.1, 1000.2 peuvent être bidirectionnels en tension uniquement ou bidirectionnels en tension et en courant. Des exemples de réalisation de tels interrupteurs 102 bidirectionnels sont représentés schématiquement sur la figure 3. De tels interrupteurs 102 peuvent être obtenus chacun en couplant deux puces formant chacune un interrupteur unidirectionnel, ou bien peuvent être réalisés chacun sur une seule puce.

Sur l'exemple a) de la figure 3, l'interrupteur 102 comporte deux transistors 108.1, 108.2 couplés en anti-série l'un à l'autre. Dans cet exemple, les transistors 108.1, 108.2 sont des MOSFET et sont de type N. Le drain du premier transistor 108.1 forme une première borne de connexion 110 de l'interrupteur 102, le drain du deuxième transistor 108.2 forme une deuxième borne de connexion 112 de l'interrupteur 102, et les sources des transistors 108.1, 108.2 sont couplées l'une à l'autre. Les diodes visibles et couplées parallèlement aux transistors 108.1, 108.2 correspondent aux diodes parasites de ces transistors ou à des diodes externes couplées en parallèle de ces transistors 108.1, 108.2. Dans cette configuration, la circulation d'un courant allant de la première borne de connexion 110 à la deuxième borne de connexion 112 est possible en ayant le transistor 108.1 à l'état passant et le transistor 108.2 à l'état bloqué (le courant traversant le transistor 108.2 via sa diode parasite ou la diode externe couplée en parallèle du transistor 108.2). La circulation d'un courant allant de la deuxième borne de connexion 112 à la première borne de connexion 110 est possible en ayant le transistor 108.1 à l'état bloqué (le courant traversant le transistor 108.1 via sa diode parasite ou la diode externe couplée en parallèle du transistor 108.1) et le transistor 108.2 à l'état passant.

Sur l'exemple b) de la figure 3, l'interrupteur 102 comporte, comme sur l'exemple a), deux transistors 108.1, 108.2 couplés en anti-série l'un à l'autre. Dans cet exemple b), les transistors 108.1, 108.2 sont des IGBT et sont de type N. Le collecteur du premier transistor 108.1 forme une première borne de connexion 110 de l'interrupteur 102, le collecteur du deuxième transistor 108.2 forme une deuxième borne de connexion 112 de l'interrupteur 102, et les émetteurs des transistors 108.1, 108.2 sont couplés l'un à l'autre. Les diodes visibles et couplées parallèlement aux transistors 108.1, 108.2 correspondent aux diodes parasites de ces transistors ou à des diodes externes couplées en parallèle de ces transistors 108.1, 108.2. Le fonctionnement d'un tel interrupteur est similaire à celui décrit ci-dessus pour l'exemple a).

Sur l'exemple c) de la figure 3, l'interrupteur 102 comporte un transistor 108.1 couplé en série à une diode 114. Dans cet exemple, le transistor 108.1 est un MOSFET et est de type N. Le drain du transistor 108.1 forme une première borne de connexion 110 de l'interrupteur 102, la cathode de la diode 114 forme une deuxième borne de connexion 112 de l'interrupteur 102, et la source du transistor 108.1 est couplée à l'anode de la diode 114. Dans cette configuration, la circulation d'un courant allant de la première borne de connexion 110 à la deuxième borne de connexion 112 est possible ayant le transistor 108.1 à l'état passant. La circulation d'un courant allant de la deuxième borne de connexion 112 à la première borne de connexion 110 n'est pas possible en raison de la présence de la diode 114.

Sur l'exemple d) de la figure 3, l'interrupteur 102 est similaire à celui de l'exemple c), excepté que le transistor 108.1 est un IGBT.

D'autres exemples d'interrupteurs 102 sont possibles : utilisation de commutateurs autres que des transistors, utilisation de transistors autres que des MOSFET et/ou des IGBT comme par exemple des transistors HEMT, interrupteurs comprenant différents types de transistors, utilisation de transistor(s) de type P, etc. En outre, pour les exemples c) et d) précédemment décrits, il est possible d'intervertir les composants. Ainsi, pour l'exemple c), cela revient à coupler l'anode de la diode 114 à la première borne de connexion 110, et à coupler la source du transistor 108 à la deuxième borne de connexion 112.

Dans une configuration particulière, les interrupteurs 102 des modules 1000.1, 1000.2 comportent des composants de puissance verticaux, par exemple à base de semi-conducteur à grand gap, ou large bande, tel que du SiC et/ou du GaN. L'utilisation de composants à base de semi-conducteur à grand gap pour former les interrupteurs 102 peut permettre d'avoir des vitesses de commutation des interrupteurs plus importantes qu'avec d'autres types de composants.

La figure 4 représente schématiquement un exemple de réalisation verticale d'un transistor 108. Dans cet exemple, le transistor 108 comporte des contacts électriques de source 116 et de grille 118 accessibles sur une première face du composant, et un contact électrique de drain (non visible sur la figure 4) accessible sur une deuxième face, opposée à la première face, du composant.

Un exemple de réalisation verticale d'une diode 114 est également représenté sur la figure 4. Dans cet exemple, la diode 114 comporte un contact électrique d'anode 120 accessible sur une première face du composant, et un contact électrique de cathode (non visible sur la figure 4) accessible sur une deuxième face, opposée à la première face, du composant.

Les composants des interrupteurs 102 peuvent avoir chacun un calibre en courant, c'est-à-dire une capacité de passage de courant, qui est proportionnel à la surface de semi-conducteur utilisée par chacun de ces composants. Dans une configuration particulière, chacun des interrupteurs 102 des modules 1000.1, 1000.2 peut être dimensionné pour faire passer une valeur de courant proportionnelle et plus faible que le courant destiné à être délivré par une source de courant couplée au convertisseur 2000, voire potentiellement égale à la moitié du courant destiné à être délivré par cette source de courant.

En variante, le convertisseur 2000 peut comporter plus de deux modules de puissance, par exemple deux modules dits « high-side » et deux modules dits « low-side ».

Selon une autre variante, les interrupteurs « high-side » et « low-side » peuvent être intégrés dans un même module de puissance.

La figure 5 représente schématiquement un exemple de configuration et d'agencement des mêmes interrupteurs que ceux précédemment décrits en lien avec la figure 1, mais agencés au sein d'un même module de puissance 1000. En outre, sur l'exemple de la figure 5, les diodes et les transistors des interrupteurs de la partie « high-side » sont intervertis par rapport à la configuration précédemment décrite en lien avec la figure 1, c'est-à-dire correspondent chacun à la configuration de l'exemple c) de la figure 3. Cette disposition a notamment pour avantage de permettre une bonne accessibilité des terminaux de commande des grilles des transistors sur les bords du module de puissance 1000. Toutefois, en variante, les interrupteurs de la partie « high-side » peuvent être réalisés comme précédemment décrit en lien avec la figure 1.

Dans l'exemple de la figure 5, les interrupteurs 102 de la partie « low-side » correspondent à ceux représentés pour le module 1000.2 de la figure 1. Dans cet exemple, chacun des interrupteurs 102 de la partie « low-side » est formé par une diode 114 et un transistor MOSFET 108 tels que :
- l'anode de la diode 114 est couplée électriquement à l'un des deuxièmes contacts électriques 106.1-106.3 ;
- la cathode de la diode 114 est couplée électriquement au drain du transistor 108 (connexion électrique non visible sur la figure 5) ;
- la source du transistor 108 est couplée électriquement au premier contact électrique 104.2.

Sur l'exemple de la figure 5, la source et la grille du transistor 108 de chacun des interrupteurs 102 de la partie « low-side » sont également couplées électriquement à d'autres contacts électriques 122, 124, appelés contact ou source Kelvin, servant à améliorer le pilotage de grille des transistors.

Les interrupteurs 102 de la partie « high-side » du module 1000 de la figure 5 sont par contre différents de ceux du module 1000.1 visible sur la figure 1. Dans cet exemple, chacun des interrupteurs 102 est formé par une diode 114 et un transistor MOSFET 108 tels que :
- la cathode de la diode 114 est couplée électriquement à l'un des deuxièmes contacts électriques 106.1 - 106.3 ;
- l'anode de la diode 114 est couplée électriquement à la source du transistor 108 ;
- le drain du transistor 108 est couplé électriquement au premier contact électrique 104.1.

Sur l'exemple de la figure 5, la source et la grille du transistor 108 de chacun des interrupteurs 102 « high-side » du module 1000 sont également couplées électriquement à d'autres contacts électriques 122, 124 (contact ou source Kelvin).

Dans une configuration particulière telle que celle représentée sur la figure 5, les deuxièmes contacts électriques 106.1 - 106.3 sont agencés entre les parties « high-side » et « low-side » du module de puissance 1000. De plus, les deuxièmes contacts électriques 106.1 - 106.3 sont ici formés par un empilement de couches électriquement conductrices isolées électriquement les unes des autres. Ces couches électriquement conductrices peuvent être coplanaires. En outre, ces couches peuvent être par exemple formées par :
- un assemblage ou empilement de substrats isolés double-face, par exemple en céramique de type DBC ou en résine époxy de type FR4 - PCB, ou
- un substrat isolé multicouche, par exemple en céramique de type DBC ou en résine époxy type FR4 - PCB, ou
- un assemblage ou empilement de barres de cuivre isolées (agencement type busbar laminé par exemple), ou
- un circuit imprimé multicouche flexible.

En outre, dans cet exemple, les couches 126, 128 et 130 comportent chacune une extrémité, respectivement référencée 127, 129 et 131 formant des accès électriques à ces couches et qui ne sont pas superposées les unes au-dessus des autres lorsque ces couches sont empilées les unes sur les autres.

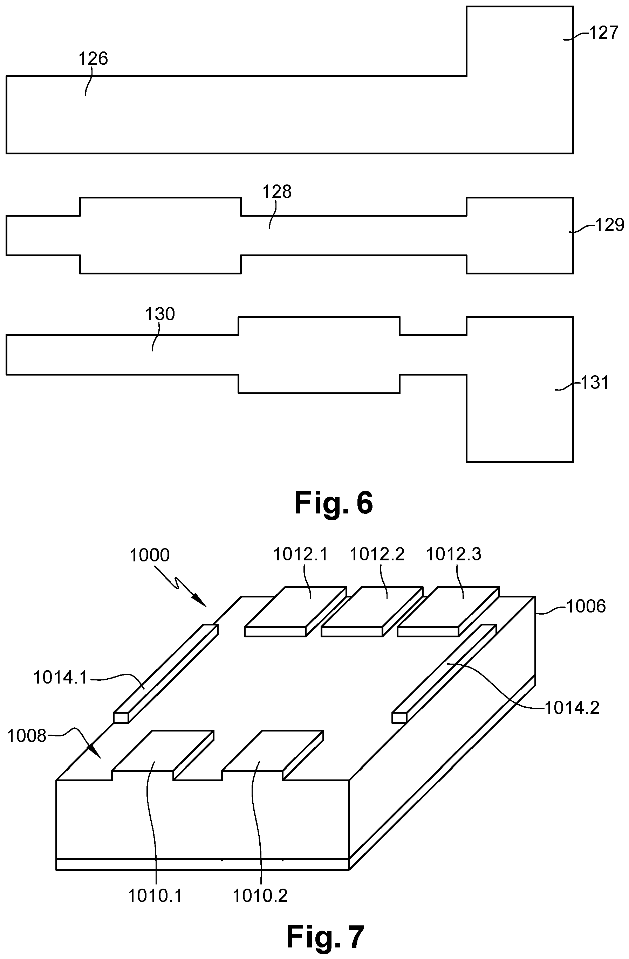

Des exemples de couches électriquement conductrices formant les deuxièmes contacts électriques 106.1 - 106.3 du module de puissance 1000 de la figure 5 sont représentées sur la figure 6. La couche 126 forme le deuxième contact électrique 106.1, la couche 128 forme le deuxième contact électrique 106.2, et la couche 130 forme le deuxième contact électrique 106.3.

Les composants semi-conducteurs 108, 114 et les contacts électrique 104.1, 104.2, 106.1 - 106.3, 122 et 124 peuvent être disposés sur un substrat 132, non visible sur la figure 5, isolé électriquement des composants du module 1000. Compte tenu du fait que les interrupteurs 102 sont juxtaposés les uns à côté des autres, le substrat 132 utilisé peut avoir, vue de dessus, une forme rectangulaire ou carrée.

Dans une configuration particulière, le module 1000 peut comporter un boîtier 1006 dans lequel les groupes d'interrupteurs « high-side » et « low-side » sont agencés. Un tel boîtier 1006 peut comporter, sur une face 1008, des plots de connexion couplés électriquement aux premiers et deuxièmes contacts électriques 104.1, 104.2, 106.1-106.3 et à des électrodes de commande des interrupteurs 102.

La figure 7 représente schématiquement un exemple de réalisation d'un tel module de puissance 1000 formant, avec le boîtier 1006, un module de puissance intégré. Sur cette figure, le boîtier 1006 comporte, sur sa face supérieure 1008, deux premiers plots de connexion 1010.1, 1010.2 chacun couplé électriquement à l'un des premiers contacts électriques 104.1, 104.2, des deuxièmes plots de connexion 1012.1 - 1012.3 chacun couplé électriquement à l'un des deuxièmes contacts électriques 106.1 - 106.3, des troisièmes plots de connexion 1014.1, 1014.2 chacun couplé électriquement aux électrodes de commande des interrupteurs 102.

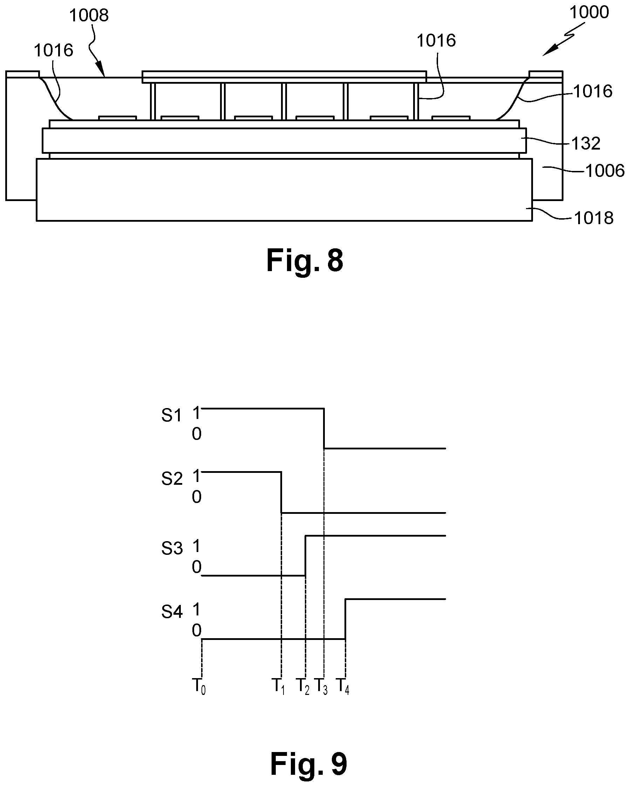

La figure 8 représente schématiquement une vue en coupe d'un exemple de réalisation du module 1000 intégré. Cette figure 8 montre notamment l'agencement des différents éléments du module de puissance 1000 précédemment décrits. Les références 1016 désignent des connexions électriques entre plots de connexion se trouvant sur la face supérieure 1008 et les contacts électriques des groupes d'interrupteurs « high-side » et « low-side ». Le module 1000 comporte en outre une semelle électriquement conductrice 1018 sur laquelle le substrat isolé 132 est solidarisé et à laquelle le boîtier 1006 est solidarisé.

Chaque interrupteur 102 est commandé par un circuit de pilotage 134, visible sur la figure 2. Le circuit de pilotage 134 peut être commun à tous les interrupteurs 102 du module de puissance 1000.

Les interrupteurs 102 et les deuxièmes contacts électriques 106.1 - 106.3 sont agencés tels que chacune des cellules de commutation soit formée par deux premiers des interrupteurs 102 disposés côte à côte et couplés à des deuxièmes contacts électriques 106.1 - 106.3 différents, et deux deuxièmes des interrupteurs 102 couplés à des deuxièmes contacts électriques 106.1 - 106.3 et qui peuvent ne pas être disposés côte à côte. Ainsi, dans chaque ensemble d'interrupteurs « high-side » ou « low-side », au moins deux interrupteurs, appelés premiers interrupteurs, des deux chemins de conduction pour lesquels la commutation est assurée par la cellule sont juxtaposés l'un à côté de l'autre.

Le circuit de pilotage 134 commande les interrupteurs 102 de chacune des cellules de commutation tel que l'un des deuxièmes interrupteurs 102 passe de l'état fermé à l'état ouvert, puis l'un des premiers interrupteurs 102 passe de l'état ouvert à l'état fermé, puis l'autre des premiers interrupteurs 102 passe de l'état fermé à l'état ouvert, puis l'autre des deuxièmes interrupteurs 102 passe de l'état ouvert à l'état fermé. L'état fermé, ou état passant ou saturé, correspond à l'état dans lequel l'interrupteur 102 laisse passer un courant, et l'état ouvert, ou état bloqué, correspond à l'état dans lequel l'interrupteur 102 ne laisse pas passer de courant.

La figure 9 représente un chronogramme de tels signaux de commande des interrupteurs 102 d'un des groupes « high-side » ou « low-side ». En prenant l'exemple de la première cellule de commutation du groupe « high-side » qui est destinée à assurer la commutation entre le premier chemin de conduction allant du premier contact électrique 104.1 au deuxième contact électrique 106.1 et le deuxième chemin de conduction allant du premier contact électrique 104.1 au deuxième contact électrique 106.2, les signaux S1 à S4 sont tels que :
- le signal S1 correspond au signal de commande de l'interrupteur 102 couplant électriquement le premier contact électrique 104.1 à la première partie du deuxième contact électrique 106.1 ;
- le signal S2 correspond au signal de commande de l'interrupteur 102 couplant électriquement le premier contact électrique 104.1 à la deuxième partie du deuxième contact électrique 106.1 ;
- le signal S3 correspond au signal de commande de l'interrupteur 102 couplant électriquement le premier contact électrique 104.1 à la première partie du deuxième contact électrique 106.2 ;
- le signal S4 correspond au signal de commande de l'interrupteur 102 couplant électriquement le premier contact électrique 104.1 à la deuxième partie du deuxième contact électrique 106.2.

Dans ce cas, entre les instants T0 et T1, les interrupteurs assurant le premier chemin de conduction sont à l'état fermé et ceux assurant le deuxième chemin de conduction sont à l'état ouvert. Les pertes par conduction sont réduites dans cet état à un minimum. Dans cette période de temps, qui est par exemple inférieure à 1 ms, l'algorithme de pilotage ou de commande rapprochée mis en oeuvre dans le circuit de pilotage 134 peut déterminer sur quelle phase, ou quel chemin de conduction, la prochaine commutation aura lieu (celle correspondant au deuxième contact électrique 106.2 dans l'exemple décrit ici).

A l'instant T1, l'interrupteur 102 du premier chemin de conduction qui est physiquement loin de ceux du deuxième chemin de conduction (celui couplant le premier contact électrique 104.1 à la deuxième partie du deuxième contact électrique 106.1) est ouvert (correspondant au passage de l'état 1 à l'état 0 du signal S2 sur le chronogramme de la figure 9). Pendant la période entre les instants T1 et T2, par exemple appelée première période d'attente, ou premier temps mort, dont la durée est par exemple inférieure à 1 µs, tout le courant injecté dans le premier contact électrique 104.1 est acheminé vers le seul interrupteur 102 fermé du premier chemin de conduction (celui couplant le premier contact électrique 104.1 à la première partie du deuxième contact électrique 106.1). Les pertes par conduction sont momentanément augmentées durant cette période.

A l'instant T2, l'interrupteur 102 du deuxième chemin de conduction qui est juxtaposé à celui du premier chemin de conduction, c'est-à-dire l'interrupteur couplant le premier contact électrique 104.1 à la première partie du deuxième contact électrique 106.2, est fermé (correspondant au passage de l'état 0 à l'état 1 du signal S3). La période entre les instants T2 et T3, appelée période de chevauchement, est par exemple inférieure à 1 µs et sert à assurer un chemin pour le courant injecté dans le premier contact électrique 104.1 durant la commutation entre les interrupteurs d'une phase à l'autre ou d'un chemin de conduction à l'autre. Comme au cours dans la période comprise entre les instants T1 et T2, les pertes par conduction restent momentanément augmentées.

A l'instant T3, l'interrupteur resté jusqu'à présent à l'état fermé du premier chemin de conduction est ouvert (correspondant au passage de l'état 1 à l'état 0 du signal S1). Pendant la période entre les instants T3 et T4, par exemple appelée deuxième période d'attente, ou deuxième temps mort, dont la durée est par exemple inférieure à 1 µs, tout le courant injecté dans le premier contact électrique 104.1 est acheminé vers le seul interrupteur 102 fermé du deuxième chemin de conduction (celui couplant le premier contact électrique 104.1 à la première partie du deuxième contact électrique 106.2). Les pertes par conduction sont momentanément augmentées durant cette période.

A l'instant T4, l'interrupteur du deuxième chemin de conduction resté ouvert jusqu'à présent (celui couplant le premier contact électrique 104.1 à la première partie du deuxième contact électrique 106.2) est fermé (correspondant au passage de l'état 0 à l'état 1 du signal S4), achevant la commutation du premier chemin de conduction vers le deuxième chemin de conduction par la première cellule de commutation.

La description ci-dessus de la commutation réalisée pour la première cellule de commutation du groupe d'interrupteurs « high-side » s'applique également pour la commutation réalisée pour les autres cellules de commutation du groupe d'interrupteurs « high-side » ainsi que pour les cellules de commutation du groupe d'interrupteurs « low-side ».

Ainsi, l'optimisation des pertes du convertisseur peut être réalisée en jouant sur la durée des temps morts décrits ci-dessus, et/ou en jouant sur l'allocation de ces temps morts dans toute la période entre les instants T1 et T4.

D'une manière générale, le convertisseur statique basé sur le module de puissance 1000 peut être de type DC/AC tel qu'un commutateur ou onduleur de courant (ou CSI pour « Current Source Inverter » en anglais, ou « Boost Type Inverter »), ou de type AC/DC tel qu'un redresseur de tension (« Buck Type Rectifier » en anglais). Le convertisseur implémenté à l'aide du module de puissance 1000 peut notamment être un convertisseur statique de puissance triphasé utilisé par exemple dans un réseau électrique ou dans une machine tournante.

Dans tous les exemples de réalisation, les modules de puissance décrits proposent une disposition spécifique des puces nues (« bare dies » en anglais) de semi-conducteur, formant les composants des interrupteurs 102, par exemple sur un substrat isolé (par exemple de nature quelconque) conjointement avec un mode de pilotage particulier assuré par le circuit de pilotage des interrupteurs. Les modules proposés peuvent permettre notamment d'améliorer :
- l'utilisation du substrat isolé grâce à une disposition compacte des interrupteurs qui sont juxtaposés les uns à côté des autres dans un espace délimité de forme rectangulaire ou carrée (contrairement à une disposition en étoile des interrupteurs), permettant d'avoir un facteur de forme de l'espace utilisé par les interrupteurs qui soit réduit et bien utilisé ;
- les performances électriques et thermiques des modules du fait que la disposition et le pilotage des interrupteurs permettent de former des cellules de commutation aux propriétés identiques les unes par rapport aux autres ;
- la fiabilité des modules du fait que tous les composants sont soumis aux mêmes contraintes de fonctionnement.

Dans tous les exemples de réalisation, les composants des interrupteurs du ou des modules de puissance peuvent fonctionner en commutation (état ouvert ou fermé, ou état saturé ou bloqué) avec une fréquence de commutation élevée, par exemple de l'ordre d'une centaine de kHz.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications données ci-dessus.

## Revendications

1. Module de puissance (1000, 1000.1, 1000.2), comprenant au moins 2n interrupteurs (102) destinés à former n cellules de commutation entre un premier contact électrique (104.1, 104.2) et n deuxièmes contacts électriques (106.1 - 106.3), n étant un nombre entier supérieur ou égal à 2, chacun des deuxièmes contacts électriques (106.1 - 106.3) étant couplé à au moins deux des interrupteurs (102), comprenant en outre un circuit de pilotage (134) des interrupteurs (102), et dans lequel :
- les interrupteurs (102) sont juxtaposés deux à deux les uns à côté des autres ;
- chacune des cellules de commutation est destinée à être formée par deux premiers des interrupteurs (102) couplés à des deuxièmes contacts électriques (106.1 - 106.3) différents et juxtaposés l'un à côté de l'autre, et par deux deuxièmes des interrupteurs (102) chacun couplé à l'un desdits deuxièmes contacts électriques (106.1 - 106.3) différents ;
- le circuit de pilotage (134) est configuré pour commander les interrupteurs (102) tel que, lors d'une commutation de chacune des cellules de commutation, l'un des deuxièmes interrupteurs (102) passe de l'état fermé à l'état ouvert, puis l'un des premiers interrupteurs (102) passe de l'état ouvert à l'état fermé, puis l'autre des premiers interrupteurs (102) passe de l'état fermé à l'état ouvert, puis l'autre des deuxièmes interrupteurs (102) passe de l'état ouvert à l'état fermé.

2. Module de puissance (1000, 1000.1, 1000.2) selon la revendication 1, dans lequel n est un nombre entier supérieur ou égal à 3.

3. Module de puissance (1000, 1000.1, 1000.2) selon la revendication 2, dans lequel deux des interrupteurs (102) sont couplés à l'un des deuxièmes contacts électriques (106.1 - 106.3), les autres interrupteurs (102) étant disposés entre lesdits deux des interrupteurs (102).

4. Module de puissance (1000, 1000.1, 1000.2) selon la revendication 2, dans lequel, pour chacune des cellules de commutation, les deuxièmes contacts électriques (106.1 - 106.3) différents auxquels sont couplés les deux deuxièmes interrupteurs (102) sont juxtaposés l'un à côté de l'autre.

5. Module de puissance (1000, 1000.1, 1000.2) selon l'une des revendications précédentes, dans lequel le circuit de pilotage (134) est configuré tel que, lors de la commutation de chacune des cellules de commutation :
- après le passage de l'état fermé à l'état ouvert dudit un des deuxièmes interrupteurs (102), ledit un des premiers interrupteurs (102) passe de l'état ouvert à l'état fermé après une première période d'attente dont la durée est inférieure à 1 µs, et/ou
- après le passage de l'état ouvert à l'état fermé dudit un des premiers interrupteurs (102), ledit autre des premiers interrupteurs (102) passe de l'état fermé à l'état ouvert après une période de chevauchement dont la durée est inférieure à 1 µs, et/ou
- après le passage de l'état fermé à l'état ouvert dudit autre des premiers interrupteurs (102), ledit autre des deuxièmes interrupteurs passe de l'état ouvert à l'état fermé après une deuxième période d'attente dont la durée est inférieure à 1 µs.

6. Module de puissance (1000, 1000.1, 1000.2) selon l'une des revendications précédentes, comportant un empilement de couches (126, 128, 130) électriquement conductrices isolées électriquement entre elles et formant les deuxièmes contacts électriques (106.1 - 106.3).

7. Module de puissance (1000, 1000.1, 1000.2) selon l'une des revendications précédentes, dans lequel les interrupteurs (102) sont bidirectionnels en tension, ou bidirectionnels en tension et en courant.

8. Module de puissance (1000, 1000.1, 1000.2) selon la revendication 7, dans lequel chaque interrupteur (102) comporte un transistor (108, 108.1) et une diode (114) couplés en anti-série, ou deux transistors (108, 108.1, 108.2) couplés en anti-série l'un à l'autre.

9. Module de puissance (1000, 1000.1, 1000.2) selon l'une des revendications précédentes, dans lequel les interrupteurs (102) comportent des composants de puissance à base de semi-conducteur à grand gap tel que du SiC et/ou du GaN.

10. Convertisseur statique de puissance (2000), comprenant au moins un module de puissance (1000, 1000.1, 1000.2) selon l'une des revendications précédentes.

11. Convertisseur statique de puissance (2000) selon la revendication 10, dans lequel le module de puissance (1000, 1000.1, 1000.2) est agencé dans un boîtier (1006) comprenant, sur une face (1008), des plots de connexions (1010.1, 1010.2, 1012.1 - 1012.3, 1014.1, 1014.2) couplés électriquement aux premiers et deuxièmes contacts électriques (104.1, 104.2, 106.1 - 106.3) et à des électrodes de commande des interrupteurs (102).

12. Convertisseur statique de puissance (2000) selon l'une des revendications 10 ou 11, configuré pour être couplé à au moins une source d'énergie électrique (2002), et dans lequel chacun des interrupteurs (102) du module de puissance (1000, 1000.1, 1000.2) est dimensionné pour faire passer une valeur de courant proportionnelle à celle du courant destiné à être délivré par la source d'énergie électrique (2002).

13. Convertisseur statique de puissance (2000) selon la revendication 12, dans lequel chacun des interrupteurs (102) du module de puissance (1000, 1000.1, 1000.2) est dimensionné pour faire passer une valeur de courant égale à la moitié de celle du courant destiné à être délivré par la source d'énergie électrique (2002).

14. Convertisseur statique de puissance (2000) selon l'une des revendications 10 à 13, dans lequel les n deuxièmes contacts électriques (106.1 - 106.3) sont communs aux interrupteurs (102) du côté haut et aux interrupteurs (102) du côté bas du convertisseur statique de puissance (2000).

15. Convertisseur statique de puissance (2000) selon l'une des revendications 10 à 14, dans lequel les n deuxièmes contacts électriques (106.1 - 106.3) sont agencés entre les interrupteurs (102) du côté haut et les interrupteurs (102) du côté bas.
